Europäisches Patentamt

European Patent Office

Office européen des brevets

(19)

(11) Publication number: **0 206 445**
A2

# EUROPEAN PATENT APPLICATION

(12)

(21) Application number: **86300841.3**

(22) Date of filing: **07.02.86**

(51) Int. Cl.⁴: **H 01 L  21/20,** H 01 L  21/203, H 01 L  29/04, H 01 L  27/06

(30) Priority: **23.02.85  GB 8504726**

(43) Date of publication of application: **30.12.86 Bulletin 86/52**

(84) Designated Contracting States: **DE FR IT NL**

(71) Applicant: **STC plc, 10, Maltravers Street, London, WC2R 3HA (GB)**

(72) Inventor: **Scovell, Peter Denis, 14 Staplecroft Spring Field, Chelmsford Essex (GB)**
Inventor: **Baker, Roger Leslie, 24 Rochford Cottages, Stansted Mountfitchet Essex (GB)**

(74) Representative: **Dennis, Mark Charles et al, STC Patent Department Edinburgh Way, Harlow Essex CM20 2SH (GB)**

(54) **Process for forming a semiconductor cell in a silicon semiconductor body and a mixed CMOS/bipolar integrated circuit formed in a plurality of such cells.**

(57) Deep cells are formed on a silicon substrate by depositing in a recess in the substrate a body of α-silicon, e.g. by plasma enhanced chemical vapour deposition, at a temperature below 550 °C. The layer is recrystallised to a single crystal layer by heating the structure to a temperature between 550 and 900 °C. The technique overcomes the problems of wafer distortion experienced in conventional high temperature epitaxial growth.

EP 0 206 445 A2

ACTORUM AG

## IMPROVEMENTS IN INTEGRATED CIRCUITS

This invention relates to integrated circuits and in particular to the formation of cells in the fabrication of such circuits.

In many integrated circuit fabrication processes it is necessary to provide a substrate silicon wafer with one or more epitaxial layers in which the circuit devices are subsequently formed. In conventional epitaxial processes silicon substrate wafers are exposed to an atmosphere containing silane or dichlorosilane at a temperature exceeding $1050^{\circ}$C. This high temperature process can cause temperature gradients across the wafer resulting in crystallographic slip, pattern distortion and wash out. Autodoping can also be a problem at the temperatures involved due to the high evaporation coefficients and is particularly severe for p-type epitaxial layers on $p^+$-type substrates. Further difficulties have been experienced in the formation of deep cells in silicon substrates. Conventionally, cells are provided by surface doping followed by diffusion or drive in. This technique however cannot be used for a production of cells deeper than about 4 microns as unacceptably long drive-in times and/or high temperatures are required.

The object of the present invention is to minimise or to overcome these disadvantages.

According to one aspect of the invention there is provided a process for forming a semiconductor cell in a major surface of a silicon semiconductor substrate by forming a region of semiconductor material in the major surface, characterised in that the major surface is selectively etched to form a depression therein, that the depression is filled with $\alpha$-silicon, and that the $\alpha$-silicon is recrystallised to form a single crystal material defining said cell.

According to the invention there is provided a process for forming a single crystal surface layer on a single crystal silicon substrate, the process including depositing a surface layer of $\alpha$-silicon on the substrate at a temperature below $550^\circ C$, and recrystallising the deposited layer at a temperature of $530^\circ$ to $900^\circ C$ to form a single crystal silicon layer.

According to a further aspect of the invention there is provided a monolithic mixed CMOS/bipolar integrated circuit including a plurality of devices formed in cells in a silicon semiconductor substrate, characterised in that the cells comprise recrystallised $\alpha$-silicon.

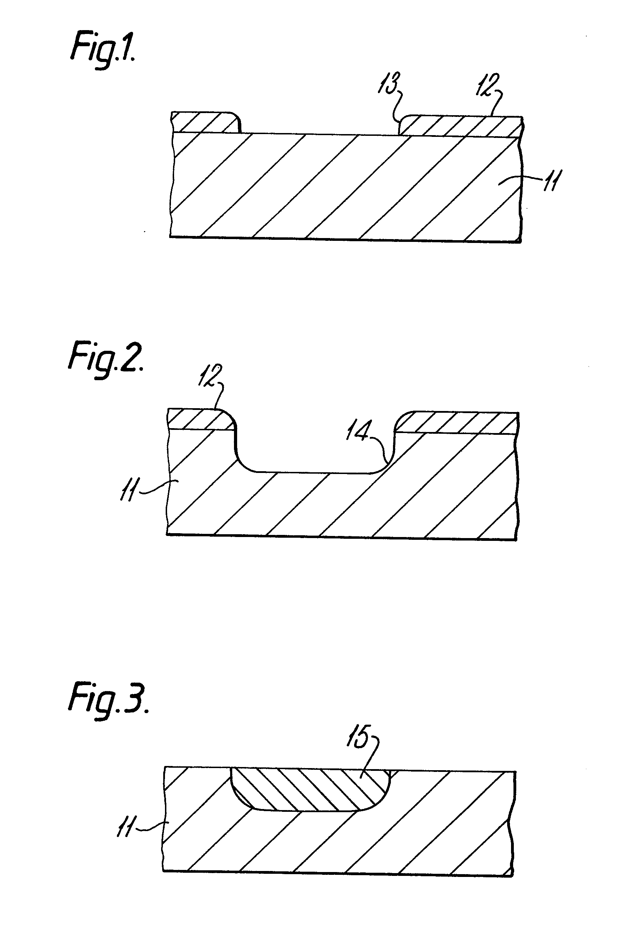

An embodiment of the invention will now be described with reference to the accompanying drawing in which Figs. 1 to 3 illustrate a sequence of steps in the formation of a cell in a semiconductor substrate body.

Referring to the drawings, a silicon single crystal semiconductor substrate 11 (Fig. 1) is masked, e.g. with a silicon nitride layer 12, and an opening 13 is formed in the mask in register with the desired points of the cell, the opening exposing the underlying semiconductor. The semiconductor 11 is then etched through the opening 13 to define a cell or depression 14 (Fig. 2). This depression 14 is typically 8 to 10 microns deep. Advantageously this etching step is performed by a dry or plasma etching technique, e.g. using a fluorinated gas mixture.

The depression 14 is filled with $\alpha$-silicon 15 (Fig. 3) preferably to the level of the substrate surface. The mask 12 together with the $\alpha$-silicon formed thereon, is removed using a planarizing etch and the assembly is located at a temperature of 530$^\circ$C to 900$^\circ$C to recrystallize the $\alpha$-silicon 15 to form a single crystal silicon cell. In general the $\alpha$-silicon 15 is doped p- or n-type so as to form a p- or n-cell whereby subsequently formed devices may be isolated from the substrate. Deep cells of this type may be employed with advantage for isolating CMOS and bipolar transistors in a mixed or merged technology monolithic integrated circuit.

In some applications the doping of the $\alpha$-silicon may be varied during deposition to provide a layered cell structure.

Typically we deposit the $\alpha$-silicon surface layer by a plasma enhanced chemical vapour deposition (PECVD) process. In this process the $\alpha$-silicon is deposited by thermal deposition from an atmosphere of silane, dichlorosilane or mixtures thereof under reduced pressure. To enhance the deposition process a radiofrequency plasma is maintained in the gas. To prevent the deposition of crystalline silicon the temperature should not exceed 600$^\circ$C. Also, to provide a sufficiently high deposition rate, the temperature should not be less than 200$^\circ$C. The film can be doped during deposition with phosphorus, arsenic, boron or mixtures thereof to provide the desired conductivity type and resistivity. Preferably this deposition stage is performed at 300 to 500$^\circ$C. When deposition to the desired layer thickness has been completed the structure is then heated to a temperature between 550 and 900$^\circ$C, preferably 600 to 800$^\circ$C, to recrystallise the film to form a single crystal epitaxial layer.

The technique can be extended to selective epitaxy by the use of an oxide masking layer. Using this process epitaxial single crystal regrowth occurs only in the mask openings. Polysilicon is formed on the oxide surface and can be subsequently selectively removed to leave the oxide isolated epitaxial material.

In a further application the technique can be used to form deep junctions in silicon. This is of particular advantage when using large diameter substrates where the high temperatures required for conventional drive-in and anneal can cause wafer distortion. For this purpose a deep well is formed by etching an oxide masked silicon substrate to the desired depth. A layer of suitably doped $\alpha$-silicon is then deposited on the substrate to completely fill the well and the structure is then recrystallised, preferably at a temperature below $800^{\circ}C$, to form a doped single crystal well. The material deposited on the mask is converted to polysilicon and is subsequently removed.

In a further application the doping of the $\alpha$-silicon can be varied during deposition to provide a graded epitaxial layer.

The technique is compatible with the low processing temperatures desirable for advanced VLSI processing on large substrates. Slip, pattern wash out and distortion are vertually eliminated and the low deposition temperatures used eliminate the risk of autodoping.

CLAIMS:-

1.      A process for forming a semiconductor cell in a major surface of a silicon semiconductor substrate by forming a region of semiconductor material in the major surface, characterised in that the major surface is selectively etched to form a depression therein, that the depression is filled with $\alpha$-silicon, and that the $\alpha$-silicon is recrystallised to form a single crystal material defining said cell.

2.      A process as claimed in claim 1, wherein the $\alpha$-silicon is deposited by a plasma enhanced chemical vapour deposition process.

3.      A process as claimed in claim 2, wherein the $\alpha$-silicon is deposited from silane, dichlorosilane or mixtures thereof.

4.      A process as claimed in claim 1, 2 or 3, wherein the $\alpha$-silicon is crystallised at temperatures of 550 to 900$^{\circ}$C.

5.      A process as claimed in any one of claims 1 to 4, wherein the $\alpha$-silicon is doped with phosphorus, arsenic, boron or mixtures thereof.

6.      A process as claimed in claim 5, wherein the doping of the $\alpha$-silicon is varied during deposition to provide a layered structure.

7.      A process as claimed in any one of claims 1 to 6, wherein the cell is from 8 to 10 microns in depth.

8.      A process for forming a semiconductor cell substantially as described herein with reference to and as shown in Figs. 1 to 3 of the accompanying drawings.

9.      A monolithic mixed CMOS/bipolar integrated circuit including a plurality of devices formed in cells in a silicon semiconductor substrate, characterised in that the cells comprise recrystallised $\alpha$-silicon.

10.     A monolithic mixed CMOS/Bipolar integrated circuit provided with a plurality of cells formed by a process as claimed in any one of claims 1 to 8.

11.　　　A process for forming a single crystal surface layer on a single crystal silicon substrate, the process including depositing a surface layer of $\alpha$-silicon on the substrate at a temperature below 550°C, and recrystallising the deposited layer at a temperature of 530° to 900°C to form a single crystal silicon layer.

12.　　　A process as claimed in claim 11 and substantially as described herein with reference to the accompanying drawings.

*Fig.1.*

*Fig.2.*

*Fig.3.*